(19) Europäisches Patentamt
European Patent Office
Office européen des brevets

(11) **EP 2 869 457 B1**

(12) **EUROPEAN PATENT SPECIFICATION**

(45) Date of publication and mention
of the grant of the patent:
**29.09.2021 Bulletin 2021/39**

(21) Application number: **13808574.1**

(22) Date of filing: **14.06.2013**

(51) Int Cl.:
*H02K 29/00* (2006.01)  *G01R 33/028* (2006.01)
*H02K 1/27* (2006.01)  *H02P 21/32* (2016.01)

(86) International application number:
**PCT/JP2013/066515**

(87) International publication number:
**WO 2014/002804 (03.01.2014 Gazette 2014/01)**

(54) **CONTROL SYSTEM**

STEUERSYSTEM

SYSTÈME DE COMMANDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.06.2012 JP 2012144651**

(43) Date of publication of application:
**06.05.2015 Bulletin 2015/19**

(73) Proprietor: **Kabushiki Kaisha Toshiba
Minato-ku
Tokyo 105-8001 (JP)**

(72) Inventors:
• **TANIGUCHI, Shun
Tokyo 105-8001 (JP)**

• **YASUI, Kazuya
Tokyo 105-8001 (JP)**
• **YUUKI, Kazuaki
Tokyo 105-8001 (JP)**
• **NAKAZAWA, Yosuke
Tokyo 105-8001 (JP)**

(74) Representative: **AWA Sweden AB
Junkersgatan 1
582 35 Linköping (SE)**

(56) References cited:
**JP-A- 2000 060 038**  **JP-A- 2000 060 038**
**JP-A- 2005 333 761**  **JP-A- 2008 079 489**
**JP-B2- 3 401 155**  **US-A1- 2011 234 135**

• **None**

EP 2 869 457 B1

## Description

### FIELD

Embodiments described herein relate generally to a control system.

### BACKGROUND

In a rotational sensorless control device of a permanent magnet synchronous motor, estimation of the initial magnetic-pole position at the time of activation from an idle state is performed using saliency. Hence, it is necessary to estimate the magnetic-pole direction.

As far as estimation of the magnetic-pole direction is concerned, an estimation method has been proposed in which magnetic saturation is put to use. An example of this is presented in US 2011/0234135 A1. Another known system is disclosed in JP2000060038A.

In the conventional estimation method mentioned above, the magnetic-pole direction is estimated by making use of the fact that the inductance in the direction of magnetic flux undergoes a monotonic decrease in reaction to an increment in the current in the north pole direction.

Thus, the conventional technology could not be implemented in the case in which, in reaction to an increment in the current in the north pole direction, the inductance in the direction of magnetic flux does not undergo a monotonic decrease but has a local maximum point.

### CITATION LIST

Patent Literature:

Patent Literature 1: Japanese Patent No. 3719910 B

Patent Literature 2: Japanese Patent No. 3401155 B

Patent Literature 3: Japanese Patent Publication No. 2008-079489 A

### BRIEF DESCRIPTION OF DRAWINGS

FIG. 1 is a block diagram illustrating an overall configuration a rotational control device of a permanent magnet synchronous motor according to a first embodiment.

FIG. 2 is a vertical cross-sectional view illustrating an overall configuration of the permanent magnet synchronous motor.

FIG. 3 is a diagram for explaining the well-known d-axis inductance characteristic in a permanent magnet synchronous motor.

FIG. 4 is a diagram for explaining the d-axis inductance characteristic in the permanent magnet synchronous motor according to the first embodiment.

FIG. 5 is a characteristic explanation diagram.

FIG. 6 is an explanatory diagram illustrating an example of another rotor having an identical characteristic to the characteristic illustrated in FIG. 4.

FIG. 7 is an explanatory diagram illustrating the relationship between a magnetic flux density (B) and a magnetic field intensity (H).

FIG. 8 is an explanatory diagram for explaining the operating principle according to the first embodiment.

FIG. 9 is an explanatory diagram illustrating the relationship between d-axis current and d-axis inductance in the state illustrated in FIG. 8.

FIG. 10 is an explanatory diagram illustrating the relationship between the d-axis current and the d-axis inductance in a rotor in the case in which the width of a magnetic-path-forming iron core is increased.

FIG. 11 is an explanatory diagram illustrating the relationship between the d-axis current and the d-axis inductance in a stator.

FIG. 12 is an explanatory diagram illustrating the relationship between the d-axis current and the d-axis inductance in the rotor in the case in which permanent magnets are inserted in vertical holes.

FIG. 13 is an explanatory diagram illustrating the relationship between the d-axis current and the d-axis inductance in the stator in the case in which permanent magnets are inserted in vertical holes.

FIG. 14 is an explanatory diagram for explaining the d-axis inductance increment and the d-axis inductance decrement according to the first embodiment.

FIG. 15 is an explanatory diagram for explaining the amount of change occurring in the d-axis inductance according to the first embodiment due to slot harmonics.

FIG. 16 is an explanatory diagram for explaining a magnetic-pole polarity determining operation according to the first embodiment.

FIG. 17A is an explanatory diagram for explaining $\gamma$-axis voltage changes equivalent to the d-axis in another example of the magnetic-pole polarity determining operation.

FIG. 17B is an explanatory diagram for explaining the $\gamma$-axis voltage changes equivalent to the d-axis in another example of the magnetic-pole polarity determining operation.

FIG. 18 is an explanatory diagram for explaining a magnetic-pole polarity determining operation according to a second embodiment.

FIG. 19 is a block diagram illustrating an overall configuration of a magnetic-pole polarity determining unit according to the third embodiment.

FIG. 20 is an explanatory diagram illustrating the relationship between a $\gamma$-axis current command and a γ-axis current.

DETAILED DESCRIPTION

The invention is defined by the independent claim 1.

Exemplary embodiments are described below in detail with reference to the accompanying drawings.

[1] First Embodiment

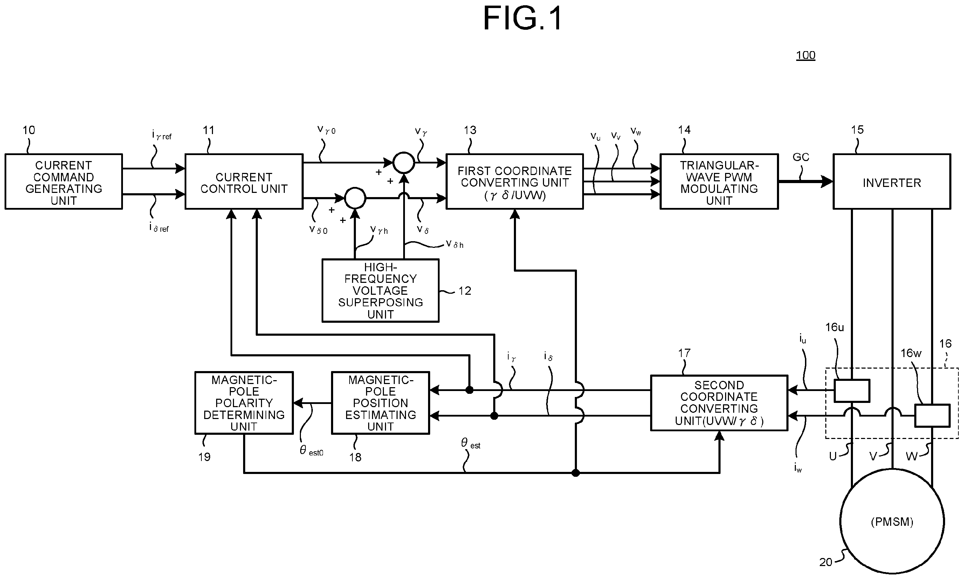

FIG. 1 is a block diagram illustrating an overall configuration a control device of a permanent magnet synchronous motor according to a first embodiment.

A motor drive device 100 mainly includes a current command generating unit 10, a current control unit 11, a high-frequency voltage superposing unit 12, a first coordinate converting unit 13, a triangular-wave PWM modulating unit 14, an inverter 15, a current detecting unit 16, a second coordinate converting unit 17, a magnetic-pole position estimating unit 18, and a magnetic-pole polarity determining unit 19.

In the configuration described above, the current command generating unit 10, the current control unit 11, the high-frequency voltage superposing unit 12, the first coordinate converting unit 13, the triangular-wave PWM modulating unit 14, the current detecting unit 16, the second coordinate converting unit 17, the magnetic-pole position estimating unit 18, and the magnetic-pole polarity determining unit 19 collectively function as an inverter control unit.

The current command generating unit 10 outputs a flux current command signal $i_{\gamma ref}$ and a torque current command signal $i_{\delta ref}$. Moreover, the current that is output by the inverter 15 at the time of determining the magnetic-pole polarity is also controlled using the flux current command signal $i_{\gamma ref}$ and the torque current command signal $i_{\delta ref}$ output by the current command generating unit 10.

Based on the flux current command signal $i_{\gamma ref}$ and the torque current command signal $i_{\delta ref}$ input from the current command generating unit 10 as well as based on a flux current component signal iγ and a torque current component signal iδ, the current control unit 11 outputs fundamental-wave voltage command signals vγ0 and vδ0.

The high-frequency voltage superposing unit 12 superposes high-frequency voltage command signals vyh and v8h onto the fundamental-wave voltage command signals vγ0 and vδ0, respectively, to generate voltage command signals vγ and vδ, respectively; and then outputs the voltage command signals vγ and vδ to the first coordinate converting unit 13.

The first coordinate converting unit 13 performs γδ-to-UVW conversion with respect to the voltage command signals vy and vδ based on a polarized magnetic-pole position θest; generates voltage command signals vu, vv, and vw; and outputs the voltage command signals vu, vv, and vw to the triangular-wave PWM modulating unit 14.

Based on the voltage command signals vu, vv, and vw input thereto, the triangular-wave PWM modulating unit 14 generates a gate command signal (group) GC for the purpose of driving a switching transistor (for example, IGBT: Insulated Gate Bipolar Transistor) (not illustrated) that constitutes the inverter 15; and outputs the gate command signal GC to the inverter 15.

Based on the gate command signal GC, the inverter 15 generates a U-phase signal U, a V-phase signal V, and a W-phase signal W for the purpose of driving a permanent magnet synchronous motor (PMSM) 20. Then, based on the U-phase signal U, the V-phase signal V, and the W-phase signal W; the inverter 15 performs ON/OFF switching of a built-in switching element (for example, an IGBT) to convert alternate-current power into direct-current power and vice versa.

The current detecting unit 16 detects a U-phase current iu, which flows to the permanent magnet synchronous motor 20 in response to the U-phase signal U, using a current sensor 16u and detects a W-phase current iw, which flows to the permanent magnet synchronous motor 20 in response to the W-phase signal W, using a current sensor 16w; and then outputs the U-phase current iu and the W-phase current iw to the second coordinate converting unit 17. In the first embodiment, although the current values (the current response values) of two phases, namely, the U phase and the W phase are detected; it is also possible to have a configuration in which the current values of all three phases are detected.

The second coordinate converting unit 17 performs UVW-to-γδ conversion with respect to the input U-phase current iu and the input W-phase current iw based on the polarized magnetic-pole position θest. Then, the second coordinate converting unit 17 outputs the flux current component signal iy and the torque current component signal iδ, which are generated as a result of the UVW-to-γδ conversion, to the magnetic-pole position estimating unit 18 and the current control unit 11.

The magnetic-pole position estimating unit 18 refers to the current component signal iy (a current response value) and the torque current component signal iδ (a current response value), and estimates the magnetic-pole position of the permanent magnet synchronous motor 20.

As far as the technique of estimating the magnetic-pole position is concerned, the technique disclosed in, for example, Patent Literature 1 is implemented.

That is, the detected current is passed through a bandpass filter, and a value equivalent to a magnetic-pole position error is obtained by performing calculations. Then, the obtained value is input to a controller, and the angular velocity is estimated. Subsequently, the magnetic-pole position is estimated by integrating the estimated angular velocity. Alternatively, the magnetic-pole position can be calculated directly from the high-frequency current.

Thus, based on the flux current component signal iy and the torque current component signal iδ that are input, the magnetic-pole position estimating unit 18 estimates the magnetic-pole position and outputs a magnetic-pole position estimation signal θest0 to the magnetic-pole polarity determining unit 19.

In the estimation of the magnetic-pole position, saliency of a rotor is put to use. For that reason, it is not possible to estimate the magnetic-pole direction. Thus, there is a possibility that a position in the direction displaced by 180° (deg) is obtained as the magnetic-pole position.

Hence, in the estimation of the magnetic-pole position, it is necessary to determine the magnetic-pole direction.

Based on the magnetic-pole position estimation signal θest0 input thereto, the magnetic-pole polarity determining unit 19 generates the polarized magnetic-pole position θest; and outputs the polarized magnetic-pole position θest to the first coordinate converting unit 13 and the second coordinate converting unit 17. That is, the magnetic-pole polarity determining unit 19 determines the north pole and the south pole by making use of the magnetic saturation of the rotor iron core and, in the case in which the magnetic-pole position estimated by the magnetic-pole position estimating unit 18 is displaced by 180° (deg), outputs a value obtained by inverting the polarized magnetic-pole position θest corresponding to the magnetic-pole polarity by 180° (deg) from the magnetic-pole position estimation signal θest0.

Prior to the explanation of specific operations performed in the motor drive device 100, the explanation is given about a configuration of the permanent magnet synchronous motor 20 in which the first embodiment is implemented.

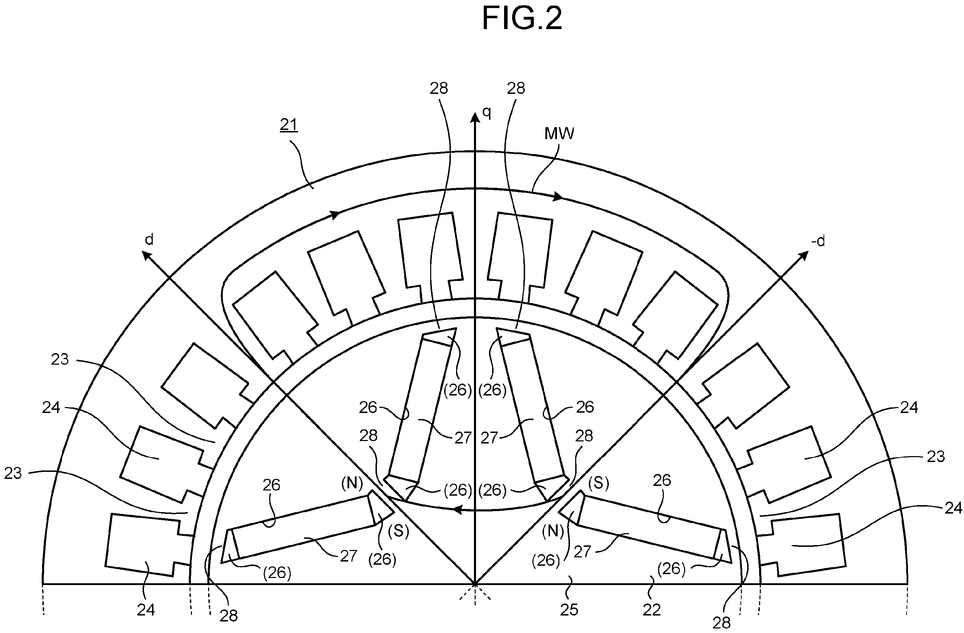

FIG. 2 is a vertical cross-sectional view illustrating an overall configuration of the permanent magnet synchronous motor.

The permanent magnet synchronous motor 20 includes a stator 21 and a rotor 22, and generates a torque for rotating the rotor 22 using the magnetic interactions that occur due to the magnetic field which is formed by a three-phase alternating current flowing to each excitation phase.

In the stator 21, stator teeth 23 and stator slots 24 are arranged in an alternating manner.

In the rotor 22, a plurality of vertical holes (air gaps) 26 is formed at predetermined positions of a rotor iron core 25 so as to isolate the magnetic poles. In each vertical hole 26, at least a single permanent magnet 27 is inserted and fixed to form a magnetic pole. Moreover, at both sides of each permanent magnet 27, a magnetic-path-forming iron core 28 is disposed for the purpose of forming a local magnetic path that loops inside the rotor iron core 25.

Firstly, the explanation is given about the characteristic of the permanent magnet synchronous motor 20.

In the following explanation, it is assumed that, with the north pole direction of the magnetic poles treated as a d-axis, applying a positive current as a d-axis current means applying a current that flows in the direction of current in which the magnetic flux is strengthened by the relationship between the inductance of the magnetic-pole direction and the current.

A magnetic path MW of the d-axis is as illustrated in FIG. 2, and it is assumed that a d-axis inductance $L_d$ is defined using the equation given below from a change $\Delta i_d$ in the current of the d-axis and a change $\Delta\phi_d$ in the magnetic flux of the d-axis.

[Expression 1]

$$L_d = \frac{\Delta\phi_d}{\Delta i_d}$$

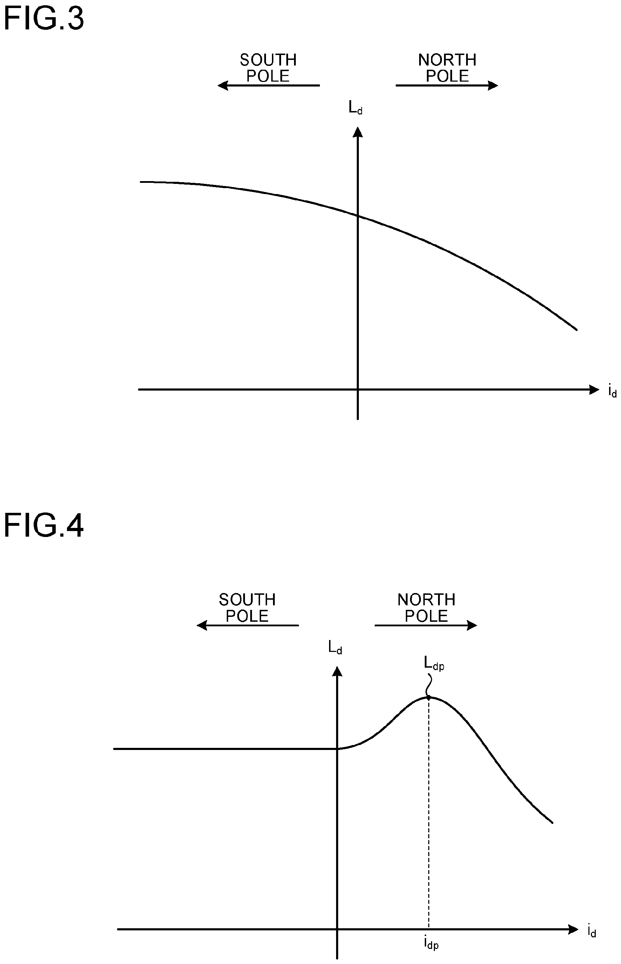

FIG. 3 is a diagram for explaining the well-known d-axis inductance characteristic in a permanent magnet synchronous motor.

FIG. 4 is a diagram for explaining the d-axis inductance characteristic in the permanent magnet synchronous motor according to the first embodiment.

Generally, in an interior permanent magnet synchronous motor (IPMSM); as illustrated in FIG. 3, along with an increase in the d-axis current, the d-axis inductance Ld undergoes a monotonic decrease.

In contrast, in the permanent magnet synchronous motor according to the first embodiment, as illustrated in FIG. 4, the d-axis inductance has a local maximum point $L_{dp}$ in the positive direction with respect to the d-axis current. When the d-axis current is increased to be greater than the local maximum point $L_{dp}$, the d-axis inductance Ld undergoes a monotonic decrease.

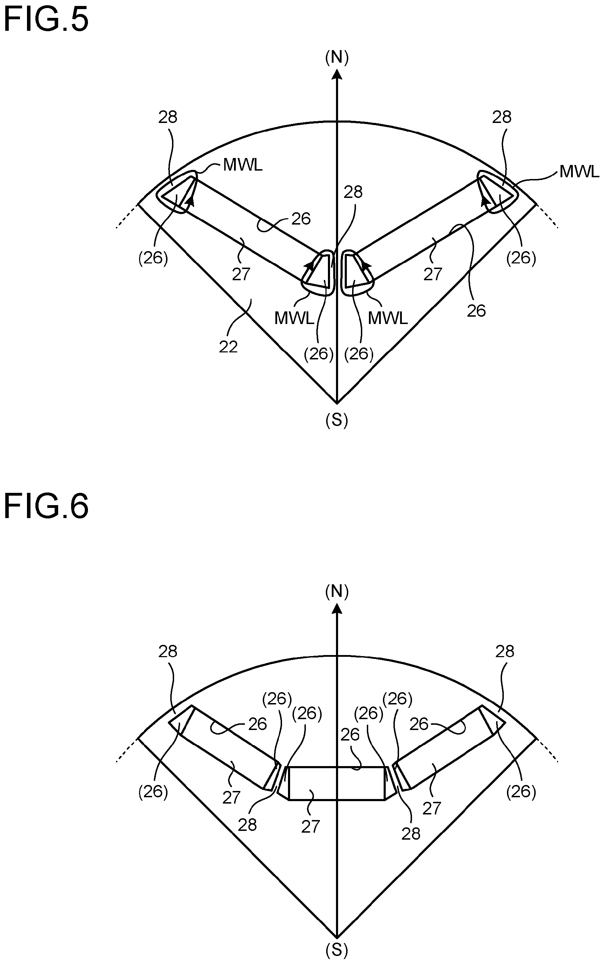

For example, as illustrated in FIG. 5, the rotor 22 of the permanent magnet synchronous motor includes a rotor iron core in which air gaps are formed so as to isolate the magnetic poles, and at least a single permanent magnet is disposed in each air gap so that the permanent magnet forms a magnetic pole. At that time, if a magnetic-path-forming iron core is disposed for the purpose of forming a local magnetic path that loops inside the rotor iron core, then the characteristic illustrated in FIG. 4 are exhibited.

Explained below is the reason for the exhibition of the characteristic as illustrated in FIG. 4.

FIG. 5 is a characteristic explanation diagram.

As illustrated in FIG. 5, a flux flows in a looping manner inside the rotor 22 along local magnetic paths MWL due to the magnetic flux, and magnetic saturation occurs in the magnetic-path-forming iron core 28 due to the magnetic flux. At that time, if a positive current is applied to the d-axis, the flux that loops the stator 21 increases but the flux that loops inside the rotor 22 decreases. For that reason, the magnetic saturation of the magnetic-path-forming iron core 28 is released, and the d-axis inductance Ld increases in a gradual manner.

If the d-axis current is further increased, then magnetic saturation occurs in the magnetic path of the stator iron core and the d-axis inductance Ld goes on decreasing. As a result, the characteristic illustrated in FIG. 4 is exhibited.

FIG. 6 is an explanatory diagram illustrating an example of another rotor having an identical characteristic to the characteristic illustrated in FIG. 4.

In the arrangement of the permanent magnets 27 illustrated in FIG. 6 too, the magnetic-path-forming iron core 28 that segmentalizes the vertical holes (air gaps) 26 undergoes magnetic saturation due to the magnetic flux. Hence, the characteristic illustrated in FIG. 4 is exhibited in an identical manner.

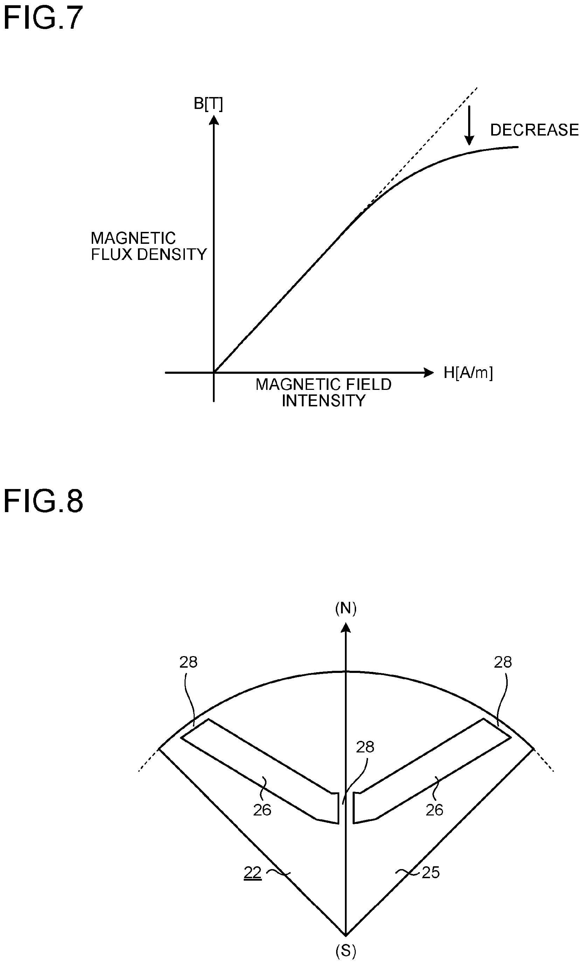

FIG. 7 is an explanatory diagram illustrating the relationship between a magnetic flux density (B) and a magnetic field intensity (H).

Herein, as illustrated in FIG. 7, magnetic saturation points to a decrease in the increase of the magnetic flux density (B) to a level lower than the linear increase in reaction to an increase in the magnetic field intensity H.

Thus, in reaction to an increase in the magnetic field intensity H that accompanies an increase in the current, the increase in the magnetic flux density B decreases to a lower level than the linear increase. For that reason, the inductance becomes smaller.

The value of the d-axis inductance $L_d$ at the local maximum point $L_{dp}$ is decided in the following manner.

FIG. 8 is an explanatory diagram for explaining the operating principle according to the first embodiment.

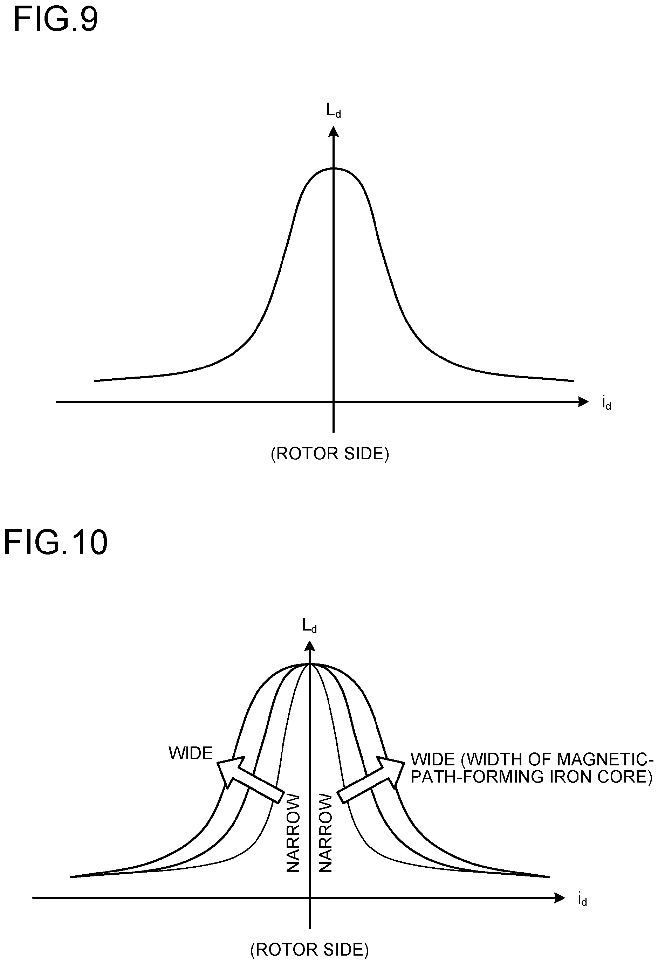

FIG. 9 is an explanatory diagram illustrating the relationship between the d-axis current and the d-axis inductance in the state illustrated in FIG. 8.

Firstly, as illustrated in FIG. 8, an electrical motor is considered in which the rotor 22 has only the vertical holes (air gaps) 26 arranged at predetermined positions of the rotor iron core 25 so as to isolate the magnetic poles, and does not have magnets disposed therein.

At that time, the d-axis inductance Ld exhibits the characteristic as illustrated in FIG. 9 due to the fact that, when the magnetic flux density B is increased, the magnetic-path-forming iron core 28 that segmentalizes the vertical holes (air gaps) 26 undergoes magnetic saturation.

That is, when the magnetic-path-forming iron core 28 that segmentalizes the vertical holes (air gaps) 26 undergoes magnetic saturation and when the flux increases to a certain level and above, then the d-axis inductance Ld stops undergoing a change.

FIG. 10 is an explanatory diagram illustrating the relationship between the d-axis current and the d-axis inductance in the rotor in the case in which the width of the magnetic-path-forming iron core 28 is increased.

When the width of the magnetic-path-forming iron core 28 that segmentalizes the vertical holes (air gaps) 26 is increased, the magnetic saturation does not occur easily. That leads to an increase in the area in which the d-axis inductance Ld is large as illustrated in FIG. 10.

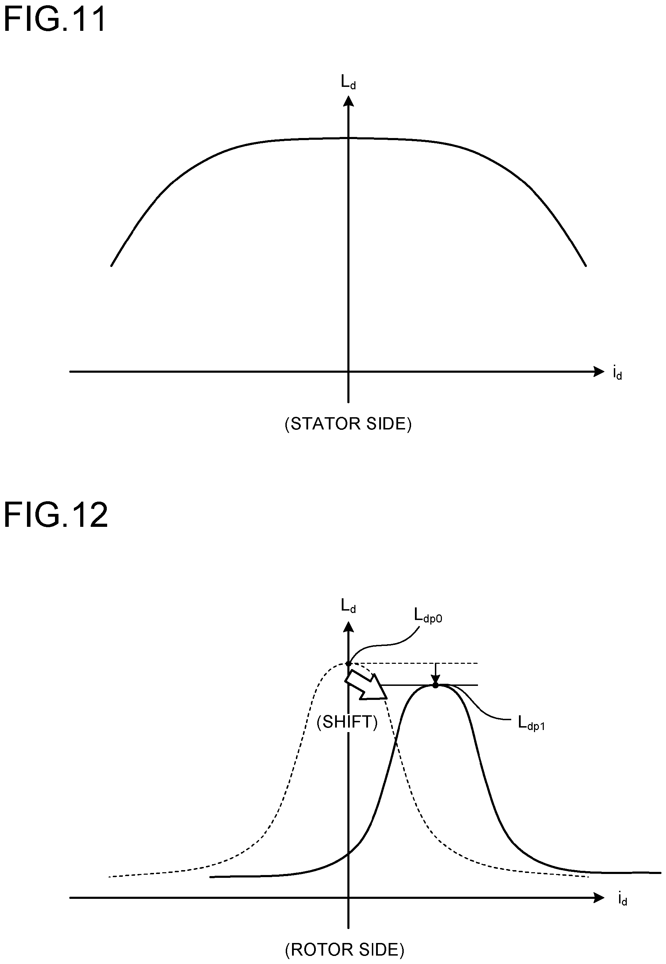

FIG. 11 is an explanatory diagram illustrating the relationship between the d-axis current and the d-axis inductance in the stator.

As illustrated in FIG. 11, along with an increase in the current in the stator, magnetic saturation progresses in a gentle way and the d-axis inductance Ld goes on decreasing. Meanwhile, if there are no magnets disposed; then, as illustrated in FIG. 9 and FIG. 11, there is no difference in the d-axis inductance Ld regardless of whether a positive d-axis current id is applied or a negative d-axis current id is applied.

The following explanation is given about the changes in the d-axis inductance Ld in the case in which permanent magnets are inserted as illustrated in FIG. 5.

FIG. 12 is an explanatory diagram illustrating the relationship between the d-axis current and the d-axis inductance in the rotor in the case in which permanent magnets are inserted in vertical holes.

When the permanent magnets 27 are inserted in the vertical holes 26, then a flux flows in a looping manner inside the rotor 22 along the local magnetic paths MWL due to the magnetic flux, and magnetic saturation occurs in the magnetic-path-forming iron core 28 that segmentalizes the vertical holes (air gaps) 26. When a positive d-axis current id is applied to the d-axis, the magnetic saturation eases up due to the d-axis current id.

For that reason, as far the characteristic is concerned, the characteristic illustrated in FIG. 9 is shifted to the positive direction of the d-axis current id as illustrated in FIG. 12. Herein, since the iron core of the magnetic path MW of the d-axis undergoes magnetic saturation in some degree, a local maximum point Ldp1 (<Ldp0) drops to a lower value.

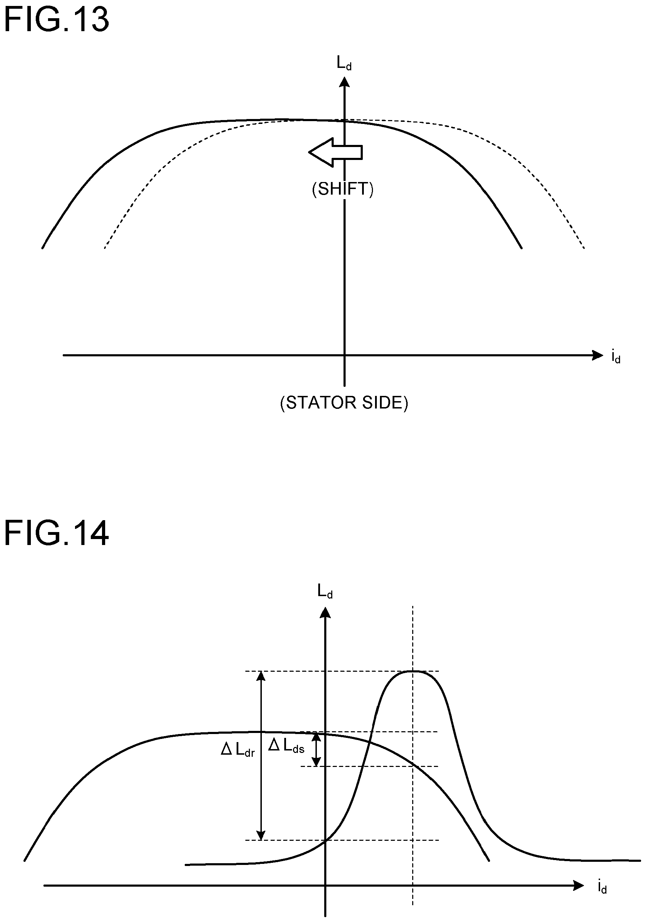

FIG. 13 is an explanatory diagram illustrating the relationship between the d-axis current and the d-axis inductance in the stator in the case in which permanent magnets are inserted in vertical holes.

When the permanent magnets 27 are inserted in the vertical holes 26, magnetic saturation progresses due to the magnetic flux, and the characteristic of the d-axis inductance Ld illustrated in FIG. 11 gets shifted in the negative direction of the d-axis current id.

Meanwhile, the amount of shift of the d-axis current id in the positive direction as illustrated in FIG. 12 as well as the amount of shift of the d-axis current id in the negative direction as illustrated in FIG. 13 is decided according to the interlinkage magnetic flux content of the d-axis.

With reference to FIG. 12, when the interlinkage magnetic flux content attributed to the permanent magnets 27 becomes equal to the interlinkage magnetic flux content generated due to the d-axis current id, the loop of the magnetic flux passes entirely through the stator 21. Consequently, the flux lopping inside the rotor, that is, the flux passing through the magnetic-path-forming iron core 28, which segmentalizes the vertical holes (air gaps) 26, disappears and the magnetic saturation of the magnetic-path-forming iron core 28 is reduced to zero. Hence, the d-axis inductance Ld takes the local maximum value.

Meanwhile, with reference to FIG. 13, the shift in the negative direction occurs by an amount equal to the magnetic flux looping the stator at zero current.

Thus, the combined characteristics of the rotor and the stator appear as the overall characteristic.

FIG. 14 is an explanatory diagram for explaining the d-axis inductance increment and the d-axis inductance decrement according to the first embodiment.

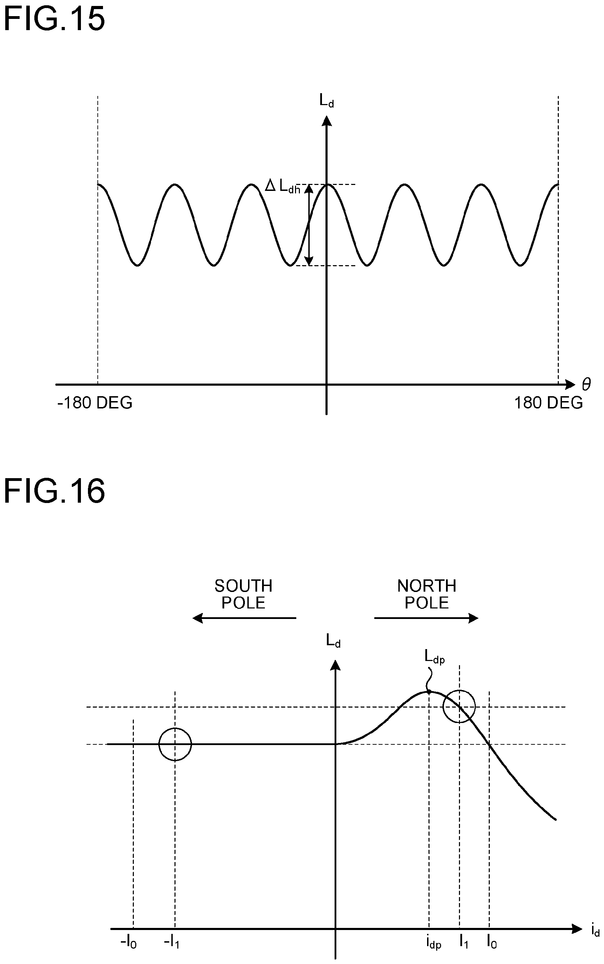

FIG. 15 is an explanatory diagram for explaining the amount of change occurring in the d-axis inductance according to the first embodiment due to slot harmonics.

Meanwhile, in order to determine the magnetic-pole polarity in a stable manner, it is necessary to increase the difference between the d-axis inductances $L_d$. In order to increase the difference between the d-axis inductances $L_d$, the rotor 22 and the stator 21 can be designed in such a way that, when the d-axis current id is applied at which the d-axis inductance $L_d$ of the rotor 22 is equal to the local maximum point, the increment in that d-axis inductance ($\Delta L_{dr}$ illustrated in FIG. 14) is sufficiently larger than the decrement in the d-axis inductance $L_d$ of the stator 21 ($\Delta L_{ds}$ illustrated in FIG. 14).

Particularly, if the difference between the d-axis inductance increment $\Delta L_{dr}$ and the d-axis inductance decrement $\Delta L_{ds}$ is set to be greater than the amount of change ($\Delta L_{dh}$ illustrated in FIG. 15) occurring in the d-axis inductance due to slot harmonics, then there is no change in rotational position of the rotor thereby making it possible to determine the magnetic-pole polarity in a stable manner.

Meanwhile, although explained later in the description of the operations performed by the magnetic-pole polarity determining unit 19; in order to make use of the d-axis inductance Ld, the changed portion of the d-axis current is put to use. As described earlier, the area having a large d-axis inductance near the local maximum point of the d-axis inductance is determined according to the width of the iron core that segmentalizes the air gaps as illustrated in FIG. 10. Thus, the width of the magnetic-path-forming iron core 28 can be decided in such a way that the d-axis inductance does not undergo a substantial change in reaction to the change in the d-axis current id made by the magnetic-pole polarity determining unit 19.

Given below is the explanation of the operations performed by the magnetic-pole polarity determining unit 19.

In the conventional technology, as illustrated in FIG. 3, the characteristic that is put to use indicates that, along with an increase in the d-axis current id, the d-axis inductance undergoes a monotonic decrease. For example, in Patent Literature 2, both positive and negative biases are applied to the d-axis current, and the direction in which the amount of change in the high-frequency current (equivalent to the reciprocal of the d-axis inductance) is greater (i.e., the direction in which the d-axis inductance is smaller) at that time is determined to be the north pole.

In contrast, as illustrated in FIG. 4, the permanent magnet synchronous motor 20 according to the first embodiment has the local maximum point Ldp in the north pole direction.

FIG. 16 is an explanatory diagram for explaining a magnetic-pole polarity determining operation according to the first embodiment.

As illustrated in FIG. 16, when a positive d-axis current and a negative d-axis current having the same absolute value are applied to the d-axis, the current values (the current amplitudes) at which the inductances are equal are referred to as I0. Herein, a current satisfying I1<I0 is applied to the positive and negative sides.

As a result, as illustrated in FIG. 16, the d-axis inductance on the north pole side becomes greater than the d-axis inductance on the south pole side. Hence, the magnetic-pole polarity determining unit 19 determines that the direction in which the d-axis inductance is greater points to the north pole. In this way, even in a permanent magnet synchronous motor in which, as illustrated in FIG. 4, the d-axis inductance Ld has the local maximum point in the positive direction with respect to the d-axis current and undergoes a monotonic decrease when the d-axis current is increased to be greater than the local maximum point, it becomes possible to perform magnetic-pole polarity determination.

In this case, if the conventional technology is put to use in which the d-axis inductance undergoes a monotonic decrease, it becomes necessary to increase the d-axis current id to a level equal to or greater than the current value I0. Hence, as compared to the conventional technology, it becomes possible to determine the polarity with a smaller current (=I1<I0).

Thus, even if the polarity is to be determined at the time of activation, it becomes possible to reduce the current applied to the permanent magnet synchronous motor. That enables achieving reduction in the noise as well reduction in torque shocks while determining the polarity.

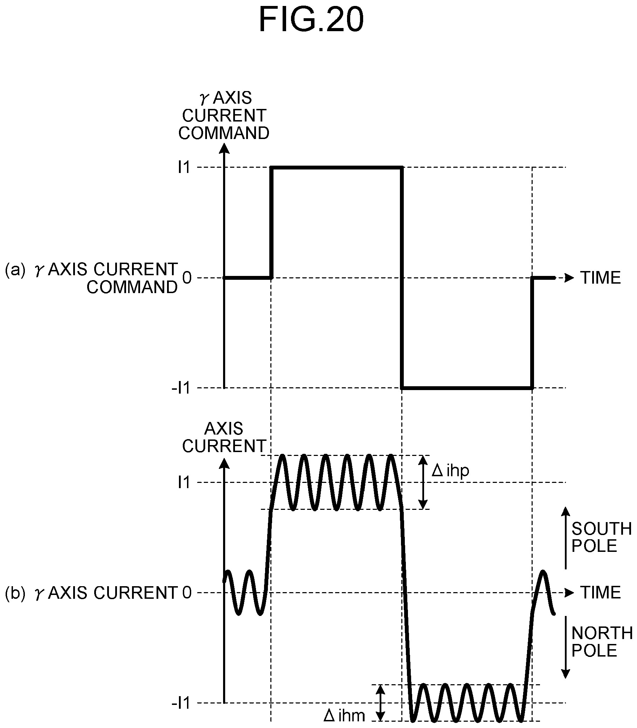

FIG. 20 is an explanatory diagram illustrating the relationship between a γ-axis current command and a γ-axis current.

More particularly, for example, as illustrated in FIG. 20(a), the current command generating unit 10 applies both positive and negative biases (I1≤I0) to a γ-axis current command corresponding to the d-axis. The δ-axis current command is assumed to be 0. At that time, due to voltage commands vγ and vδ that are generated by adding high-frequency voltages vγh and vδh to voltage commands vγ0 and vδ0 corresponding to a γ-axis current command, the γ-axis current flows as illustrated in FIG. 20(b). The amount of change in the high-frequency current at that time is equivalent to the reciprocal of the d-axis inductance. Thus, by comparing a high-frequency current change amount Δihp at the time of applying bias to the positive side and a high-frequency current change amount Δihm at the time of applying bias to the negative side, the direction in which the amount of change is greater (i.e., the direction in which the d-axis inductance is smaller) is determined to be the south pole (with reference to FIG. 20, since Δihp>Δihm is satisfied and the positive side becomes the south pole, the magnetic-pole polarity is reversed). Particularly, as illustrated in FIG. 16, if the d-axis current id during polarity determination is set, that is, if the current I1=Idp is satisfied; then the difference between the positive and negative inductances is maximized thereby making it possible to increase the SN ratio in the polarity determination.

Given below is the explanation of a modification example of the first embodiment not falling within the scope of the claimed subject-matter.

In the modification example, in the motor drive device 100 illustrated in FIG. 1, the current control unit 11 and the high-frequency voltage superposing unit 12 are not disposed. Moreover, the configuration is such that the flux current component signal iγ and the torque current component signal iδ that are output by the second coordinate converting unit 17 at the time of generating the voltage command signals vγ and vδ, respectively, are not used. Instead, the current command generating unit 10 is configured to output the voltage command signals vγ and vδ.

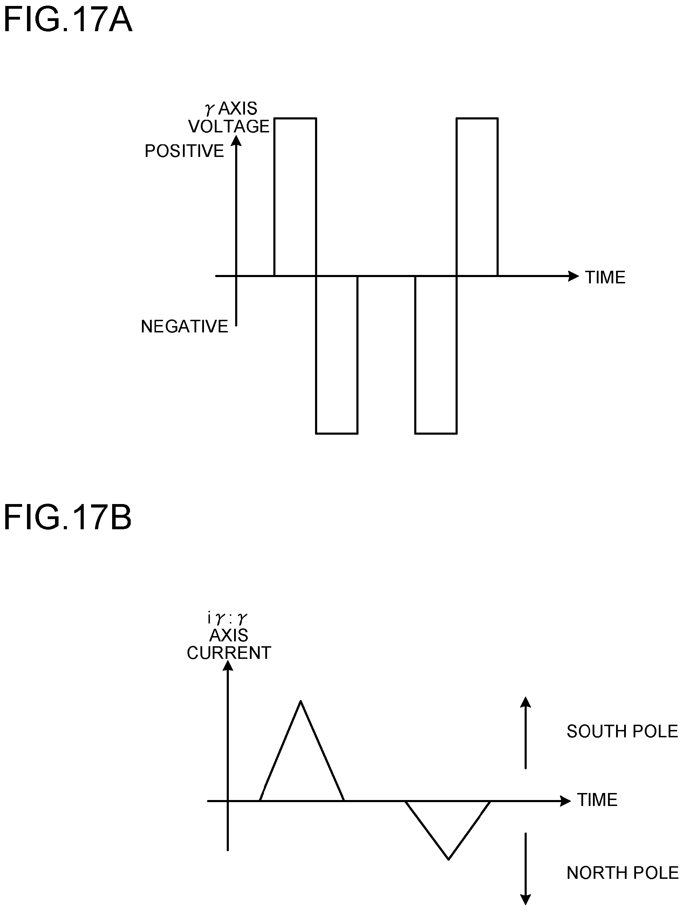

FIG. 17A is an explanatory diagram for explaining the γ-axis voltage changes equivalent to the d-axis in another example of the magnetic-pole polarity determining operation.

FIG. 17B is an explanatory diagram for explaining the γ-axis voltage changes equivalent to the d-axis in another example of the magnetic-pole polarity determining operation.

As another example of polarity determination, when positive and negative fixed voltages are applied in the γ-axis direction as illustrated in FIG. 17A, the amplitude of the γ-axis voltage (equivalent to the reciprocal of the d-axis inductance) is checked and the direction in which the amplitude is greater is determined to be the south pole as illustrated in FIG. 17B.

In this case, the voltage amplitude is determined in such a way that the current amplitude I1 in the south pole direction satisfies I1<I0. Particularly, if the voltage amplitude is determined in such a way that the current amplitude I1 in the south pole direction is equal to I0, then the difference between the amplitudes of the d-axis current id is maximized thereby making it possible to increase the SN ratio.

Alternatively, the amplitude of the γ-axis voltage (equivalent to the reciprocal of the d-axis inductance) is checked in response to the application of a fixed voltage; and, if the amplitude is equal to or greater than a threshold value, it is determined to be the south pole. The voltage amplitude is decided in such a way that the current amplitude I1 in the south pole direction satisfies I1≤I0. Particularly, if the voltage amplitude is determined in such a way that the current amplitude I1 in the south pole direction is equal to I0, then the current amplitude is maximized thereby making it possible to increase the SN ratio.

Still alternatively, an alternating-voltage generating unit is disposed that superposes an alternating voltage having positive/negative symmetry to the γ-axis. Then, the amplitude in the positive direction and the amplitude in the negative direction of the γ-axis current iγ, which is generated due to the alternating voltage, is detected; and the direction in which the current amplitude (equivalent to the reciprocal of the d-axis inductance) is greater is determined to be the south pole direction.

In this case, the voltage amplitude is decided in such a way that the current amplitude I1 in the south pole direction satisfies I1≤I0. Particularly, if the voltage amplitude is determined in such a way that the current amplitude I1 in the south pole direction is equal to I0, then the difference between the current amplitudes is maximized thereby making it possible to increase the SN ratio.

Still alternatively, if the fact that the d-axis inductance on the north pole side increases in an area satisfying id<i0, it becomes possible to determine the magnetic-pole direction in an identical manner.

In the explanation given above, the magnetic-pole position estimating unit 18 and the magnetic-pole polarity determining unit 19 are configured separately. However, alternatively, the magnetic-pole position estimating unit 18 and the magnetic-pole polarity determining unit 19 can also be configured in an integrated manner. For example, when the d-axis current having positive/negative symmetry is applied, according to a method in which the characteristic of magnetic saturation of differing in positivity and negativity only in the d-axis direction is used in estimating the magnetic-pole position, it becomes possible to perform magnetic-pole position estimation including magnetic-pole polarity determination. At that time, if the current amplitude is set to satisfy I1≤I0 and if the fact that the d-axis inductance on the north pole side increases is used, then it becomes possible to achieve the same effect as the effect achieved in the embodiment described above.

Meanwhile, the explanation given above is about sensorless control. However, alternatively, the explanation is applicable in an identical manner in estimating the initial magnetic-pole position of a pulse generator.

[2] Second Embodiment not falling within the scope of the claimed subject-matter

In a second embodiment, in a permanent magnet synchronous motor having the characteristic that the d-axis inductance has the local maximum point in the positive direction with respect to the d-axis current id and undergoes a monotonic decrease when the d-axis current is increased to be greater than the local maximum point; unlike in the first embodiment, polarity determination is performed by applying a current satisfying I1>I0 to the positive and negative sides.

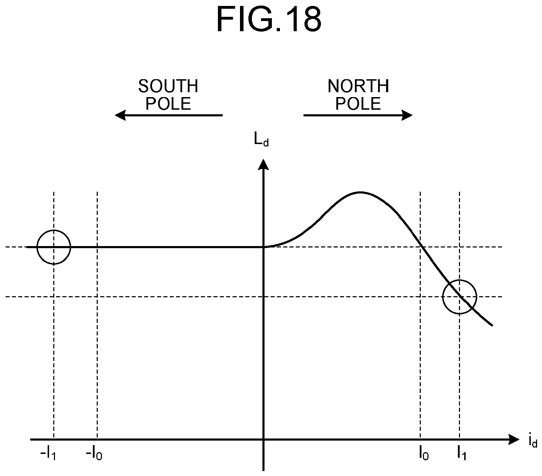

FIG. 18 is an explanatory diagram for explaining a magnetic-pole polarity determining operation according to the second embodiment.

As illustrated in FIG. 18, the d-axis inductance Ld decreases to a lower level on the north pole side than on the south pole side. Then, the magnetic-pole polarity determining unit 19 determines the direction in which the d-axis inductance is smaller to be the north pole.

In this case, unlike in the case of the first embodiment, more the increase in the d-axis current id, greater becomes the difference between the d-axis inductance Ld on the north pole side and the d-axis inductance Ld on the south pole side. The advantage thereof is that the adjustments become easier to perform and the SN ratio becomes easier to secure.

More particularly, for example, positive and negative biases (I1>I0) are applied to the d-axis current, and the direction in which the amount of change in the high-frequency current (equivalent to the reciprocal of the d-axis inductance) is greater (i.e., the direction in which the d-axis inductance is smaller) at that time is determined to be the north pole.

Moreover, if the fact that the d-axis inductance on the south pole side increases in the area satisfying id>I0 is used, then it becomes possible to determine the magnetic-pole direction in an identical manner.

In the explanation given above, the magnetic-pole position estimating unit 18 and the magnetic-pole polarity determining unit 19 are configured separately. However, alternatively, the magnetic-pole position estimating unit 18 and the magnetic-pole polarity determining unit 19 can also be configured in an integrated manner. For example, when the d-axis current having positive/negative symmetry is applied, according to a method in which the characteristic of magnetic saturation of differing in positivity and negativity only in the d-axis direction is used in estimating the magnetic-pole position, it becomes possible to perform magnetic-pole position estimation including magnetic-pole polarity determination.

At that time, if the current amplitude is set to satisfy I1>I0 and if the fact that the d-axis inductance on the south pole side increases, then it becomes possible to achieve the effect of the present invention.

Meanwhile, in the second embodiment too, the explanation is not limited to sensorless control, and is applicable in an identical manner in estimating the initial magnetic-pole position of a pulse generator.

[3] Third Embodiment not falling within the scope of the claimed subject-matter

In each embodiment described above, the explanation is given only for a case in which the permanent magnet synchronous motor that is connected and to be controlled has the characteristic illustrated in FIG. 4. In contrast, in a third embodiment, it is made possible to select between a permanent magnet synchronous motor that is connected and to be controlled has the characteristic illustrated in FIG. 3 and a permanent magnet synchronous motor that is connected and to be controlled has the characteristic illustrated in FIG. 4.

The following explanation is given only about a magnetic-pole polarity determining unit that is different than the first embodiment.

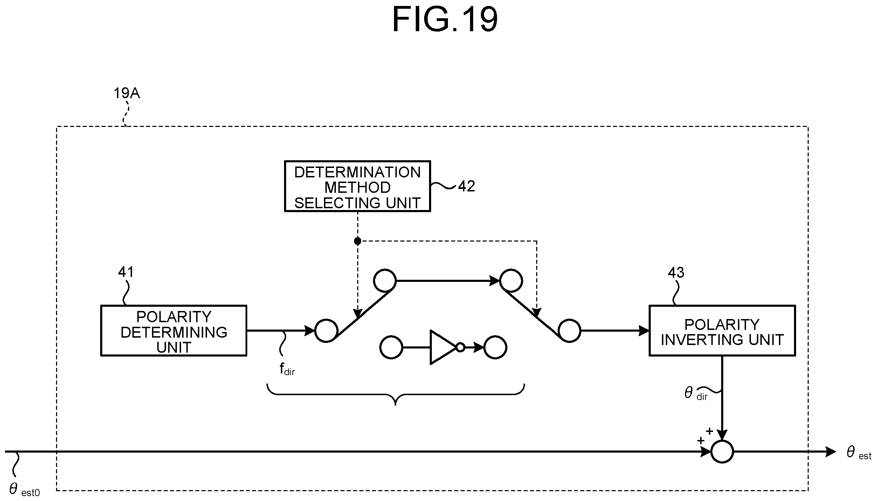

FIG. 19 is a block diagram illustrating an overall configuration of the magnetic-pole polarity determining unit according to the third embodiment.

A magnetic-pole polarity determining unit 19A according to the third embodiment is used in place of the magnetic-pole polarity determining unit 19 according to the first embodiment; and includes a polarity determining unit 41, a determination method selecting unit 42, and a polarity inverting unit 43 as illustrated in FIG. 19.

In the polarity determining unit 41 of the magnetic-pole polarity determining unit 19A, the direction in which the inductance becomes greater in reaction to the application of the positive current I1 and the negative current I1 to the d-axis is determined to be the south pole, and a polarity determination flag fdir is set. More particularly, for example, both positive and negative biases are applied to the d-axis current, and the direction in which the amount of change in the high-frequency current (equivalent to the reciprocal of the d-axis inductance) is smaller (i.e., the direction in which the d-axis inductance is greater) at that time is determined to be the south pole.

In the determination method selecting unit 42, the motor that is connected is a permanent magnet synchronous motor in which, as illustrated in FIG. 4, the d-axis inductance has the local maximum point in the positive direction with respect to the d-axis current and undergoes a monotonic decrease when the d-axis current is increased to be greater than the local maximum point; as well as inverts the polarity determination flag fdir when I1<I0 is satisfied.

As a result, the polarity inverting unit 43 refers to the fdir and accordingly determines whether or not to invert the polarity. In the case of inverting the polarity, 180° (deg) is output to a polarity inversion command θdir; the polarity of the magnetic-pole position estimation signal θest0 is inverted; and is output as the polarized magnetic-pole position θest.

According to the third embodiment, regardless of whether a permanent magnet synchronous motor has the characteristic that the d-axis inductance undergoes a monotonic decrease along with an increase in the d-axis current as illustrated in FIG. 3 or whether a permanent magnet synchronous motor has the characteristic that the d-axis inductance has the local maximum point in the positive direction with respect to the d-axis current and undergoes a monotonic decrease when the d-axis current is increased to be greater than the local maximum point; if the user only performs the setting of the determination method selecting unit 42, it becomes possible to implement a magnetic-pole polarity determining device and eventually a motor control device capable of performing magnetic-pole polarity determination.

Meanwhile, in the third embodiment too, the explanation is not limited to sensorless control, and is applicable in an identical manner in estimating the initial magnetic-pole position of a pulse generator.

Other Aspects of Embodiments not falling within the scope of the claimed subject-matter

[4.1] 1st Other Aspect

In a magnetic-pole polarity determining device according to a 1st other aspect of the embodiments, the direction of current in which the magnetic flux is strengthened by the relationship between the inductance of the magnetic-pole direction and the current is treated as the positive direction, while the direction of current in which the magnetic flux is weakened is treated as the negative direction. The magnetic-pole polarity determining device determines the magnetic-pole polarity of a permanent magnet synchronous motor having the characteristic that, when a current in the positive direction is applied, the inductance of the magnetic-pole direction has the local maximum point and undergoes a monotonic decrease when a large current is applied in the positive direction with respect to the local maximum point. Moreover, the magnetic-pole polarity determining device includes a magnetic-pole polarity determining unit that, when a current is applied in the positive direction and the negative direction with an identical predetermined current value, determines the side on which the inductance of the magnetic-pole direction (i.e., the d-axis inductance) increases as the north pole side.

[4.2] 2nd Other Aspect

According to a 2nd other aspect of the embodiments, a magnetic-pole polarity determining device determines the magnetic-pole polarity of a permanent magnet synchronous motor in which a rotor has a rotor iron core with air gaps formed thereon so as to isolate the magnetic poles; at least a single permanent magnet is disposed in each air gap to form a magnetic pole; and a magnetic-path-forming iron core is disposed for the purpose of forming a local magnetic path that loops inside the rotor iron core. Moreover, in the magnetic-pole polarity determining device, the direction of current in which the magnetic flux is strengthened by the relationship between the inductance of the magnetic-pole direction and the current is treated as the positive direction, while the direction of current in which the magnetic flux is weakened is treated as the negative direction. Furthermore, the magnetic-pole polarity determining device includes a magnetic-pole polarity determining unit that, when a current is applied in the positive direction and the negative direction with an identical predetermined current value, determines the side on which the inductance of the magnetic-pole direction (i.e., the d-axis inductance) increases as the north pole side.

[4.3] 3rd Other Aspect

According to a 3rd other aspect of the embodiments, in the first other aspect or the second other aspect, the predetermined current value (I1) is set to such a current value that is smaller than a current value at which the inductance of the magnetic-pole direction again becomes equal in the positive direction and the negative direction when, while applying an identical current in the positive direction and the negative direction from the state of zero current, the current in the positive direction is increased to a current value greater than the current value equivalent to the local maximum point.

[4.4] 4th Other Aspect

According to a 4th aspect of the embodiments, in any one of the first other aspect to the third other aspect, the predetermined current value is either set to the current value equivalent to the local maximum point or set to a current value equivalent to the neighborhood of the local maximum point.

[4.5] 5th Other Aspect

According to a 5th aspect of the embodiments, in any one of the first other aspect to the fourth other aspect, the predetermined current value is set in such a way that the difference in inductances of the magnetic-pole direction at the predetermined current value is equal to or greater than a predetermined difference.

[4.6] 6th Other Aspect

According to a 6th aspect of the embodiments, in any one of the first other aspect to the fifth other aspect, it is either possible to connect a permanent magnet synchronous motor having the characteristic that, when a large current is applied in the positive direction with respect to the local maximum point, the inductance of the magnetic-pole direction undergoes a monotonic decrease or possible to connect another type of permanent magnet synchronous motor having the characteristic that, when a current is applied in the positive direction, the inductance of the magnetic-pole direction undergoes a monotonic decrease as the current value increases. The magnetic-pole polarity determining device includes a polarity inverting unit that, when the other type of permanent magnet synchronous motor is connected, inverts the output of the magnetic-pole polarity determining unit.

[4.7] 7th Other Aspect

According to a 7th other aspect of the embodiments, in a magnetic-pole polarity determining device, the direction of current in which the magnetic flux is strengthened by the relationship between the inductance of the magnetic-pole direction and the current is treated as the positive direction, while the direction of current in which the magnetic flux is weakened is treated as the negative direction. The magnetic-pole polarity determining device determines the magnetic-pole polarity of a permanent magnet synchronous motor having the characteristic that, when a current in the positive direction is applied, the inductance of the magnetic-pole direction has the local maximum point and undergoes a monotonic decrease when a large current is applied in the positive direction with respect to the local maximum point. Moreover, the magnetic-pole polarity determining device includes a magnetic-pole polarity determining unit that, when a current is applied in the positive direction and the negative direction with an identical predetermined current value, determines the side on which the inductance of the magnetic-pole direction decreases as the north pole side. Herein, the predetermined current value is set to such a current value that is greater than a current value at which the inductance of the magnetic-pole direction again becomes equal in the positive direction and the negative direction when, while applying an identical current in the positive direction and the negative direction from the state of zero current, the current in the positive direction is increased to a current value greater than the current value equivalent to the local maximum point.

[4.8] 8th Other Aspect

According to an 8th other aspect of the embodiments, in a magnetic-pole polarity determining device, the direction of current in which the magnetic flux is strengthened by the relationship between the inductance of the magnetic-pole direction and the current is treated as the positive direction, while the direction of current in which the magnetic flux is weakened is treated as the negative direction. The magnetic-pole polarity determining device determines the magnetic-pole polarity of a permanent magnet synchronous motor having the characteristic that, when a current in the positive direction is applied, the inductance of the magnetic-pole direction has the local maximum point and undergoes a monotonic decrease when a large current is applied in the positive direction with respect to the local maximum point. Moreover, the magnetic-pole polarity determining device includes an alternating-voltage generating unit that superposes an alternating voltage having positive/negative symmetry to the magnetic-pole direction; and includes a magnetic-pole polarity determining unit that detects the amplitude in the positive direction and the amplitude in the negative direction of the current generated due to the alternating voltage and determines the direction in which the current amplitude is greater as the south pole direction.

[4.9] 9th Other Aspect

According to a 9th other aspect of the embodiments, in a permanent-magnet-synchronous-motor control device, the direction of current in which the magnetic flux is strengthened by the relationship between the inductance of the magnetic-pole direction and the current is treated as the positive direction, while the direction of current in which the magnetic flux is weakened is treated as the negative direction. The permanent-magnet-synchronous-motor control device controls a permanent magnet synchronous motor having the characteristic that, when a current in the positive direction is applied, the inductance of the magnetic-pole direction has the local maximum point and undergoes a monotonic decrease when a large current is applied in the positive direction with respect to the local maximum point. Moreover, the permanent-magnet-synchronous-motor control device includes a magnetic-pole polarity determining unit that, when a current is applied in the positive direction and the negative direction with an identical predetermined current value, determines the side on which the inductance of the magnetic-pole direction increases as the north pole side; and includes an inverter control unit that generates a gate command signal based on the determination result of the magnetic-pole polarity determining unit and controls an inverter which drives the permanent magnet synchronous motor.

[4.10] 10th Other Aspect

According to a 10th other aspect of the embodiments, a permanent-magnet-synchronous-motor control device controls a permanent magnet synchronous motor in which a rotor has a rotor iron core with air gaps formed thereon so as to isolate the magnetic poles; at least a single permanent magnet is disposed in each air gap to form a magnetic pole; and a magnetic-path-forming iron core is disposed for the purpose of forming a local magnetic path that loops inside the rotor iron core. Moreover, in the a permanent-magnet-synchronous-motor control device, the direction of current in which the magnetic flux is strengthened by the relationship between the inductance of the magnetic-pole direction and the current is treated as the positive direction, while the direction of current in which the magnetic flux is weakened is treated as the negative direction. Furthermore, the permanent-magnet-synchronous-motor control device includes a magnetic-pole polarity determining unit that, when a current is applied in the positive direction and the negative direction with an identical predetermined current value, determines the side on which the inductance of the magnetic-pole direction increases as the north pole side; and includes an inverter control unit that generates a gate command signal based on the determination result of the magnetic-pole polarity determining unit and controls an inverter which drives the permanent magnet synchronous motor.

[4.11] 11th Other Aspect

According to an 11th aspect of the embodiments, in a magnetic-pole polarity determining device, the direction of current in which the magnetic flux is strengthened by the relationship between the inductance of the magnetic-pole direction and the current is treated as the positive direction, while the direction of current in which the magnetic flux is weakened is treated as the negative direction. The magnetic-pole polarity determining device determines the magnetic-pole polarity of a permanent magnet synchronous motor having the characteristic that, when a current in the positive direction is applied, the inductance of the magnetic-pole direction has the local maximum point and undergoes a monotonic decrease when a large current is applied in the positive direction with respect to the local maximum point. A magnetic-pole polarity determining method implemented in the magnetic-pole polarity determining device includes applying a current in the positive direction and the negative direction with an identical predetermined current value; and determining, when a current is applied with the predetermined current value, the side on which the inductance of the magnetic-pole direction increases as the north pole side.

[4.12] 12th Other Aspect

According to a 12th aspect of the embodiments, a magnetic-pole polarity determining device determines the magnetic-pole polarity of a permanent magnet synchronous motor in which a rotor has a rotor iron core with air gaps formed thereon so as to isolate the magnetic poles; at least a single permanent magnet is disposed in each air gap to form a magnetic pole; and a magnetic-path-forming iron core is disposed for the purpose of forming a local magnetic path that loops inside the rotor iron core. Moreover, in the magnetic-pole polarity determining device, the direction of current in which the magnetic flux is strengthened by the relationship between the inductance of the magnetic-pole direction and the current is treated as the positive direction, while the direction of current in which the magnetic flux is weakened is treated as the negative direction. The magnetic-pole polarity determining device executed by the magnetic-pole polarity determining device includes applying a current in the positive direction and the negative direction with an identical predetermined current value and determining, when a current is applied with the predetermined current value, the side on which the inductance of the magnetic-pole direction increases as the north pole side.

The control system according to any one of embodiments, modifications, and different aspects of the embodiments enables estimation of the magnetic pole direction even in an electrical motor in which, in reaction to an increment in the current in the north pole direction, the inductance in the direction of magnetic flux has a local maximum point.

**Claims**

1. A control system (100) that controls a synchronous motor (20) comprising a stator (21) and a rotor, and having a magnet (27) inside the rotor (22), the control system being **characterized in that** the synchronous motor (20) having:

   i) a d-axis inductance with a local maximum point in a positive direction with respect to a positive d-axis current applied to the stator (21) while the positive d-axis current increases, and
   ii) a d-axis inductance that monotonically decreases when the d-axis current increases to greater than the local maximum point,

   the control system (100) further comprising:

   an inverter (15) configured to output an alternating current for driving the synchronous motor (20);
   a gate command generating unit (14) configured to generate a gate command (GC) for driving the inverter (15);
   a current detecting unit (16) configured to detect a current value of the alternating current output by the inverter (15);
   a magnetic-pole position estimating unit (18) configured to estimate a magnetic-pole position based on the current value detected by the current detecting unit (16) and generate an estimation signal;
   a control unit (11) that instructs, upon determination of magnetic-pole polarity, the gate command generating unit to generate a gate command for polarity determination so that a d-axis component of the current value detected by the current detecting unit represents a predetermined value; and
   a magnetic-pole polarity determining unit (19) configured to calculate, if the gate command for polarity determination is generated, based on the estimation signal, a first inductance value based on a positive d-axis current and a second inductance value based on a negative d-axis current, compare the first inductance value and the second inductance value, and determine a larger one of the first inductance and the second inductance value as a north pole.

2. The control system (100) according to Claim 1, wherein the gate command for polarity determination is a command indicating that an inductance value obtained from the d-axis component of the current value represents a local maximum value or a neighborhood of the local maximum value.

3. The control system (100) according to Claim 1, wherein the synchronous motor (20) includes the rotor (22) including a plurality of magnet portions made of two magnets (27), and

the two magnets of each of the magnet portions are disposed at a non-constant distance that is shortest at a portion closest to the center of the rotor and longest at a portion furthest to the center of the rotor.

4. The control system (100) according to Claim 1, wherein the rotor includes a plurality of magnet portions made of three magnets (27), and two of the three magnets of each of the magnet portions are disposed at a non-constant distance that is shortest at a portion closest to the center of the rotor (22) and longest at a portion furthest to the center of the rotor.

5. The control system (100) according to Claim 1, wherein, the control unit (11) includes:

an alternating voltage generating unit (12) that generates an alternating voltage to be superposed on a d-axis component of the alternating current output by the inverter; and

the magnetic polarity determining unit (19) determines, when the alternating voltage generated by the alternating voltage generating unit has been superposed and based on the current value detected by the current detecting unit, the side having a greater amplitude of the d-axis current as the south pole.

**Patentansprüche**

1. Steuersystem (100), das einen Synchronmotor (20) steuert, der einen Stator (21) und einen Rotor umfasst, und einen Magneten (27) innerhalb des Rotors (22) aufweist, wobei das Steuersystem **dadurch gekennzeichnet ist, dass**
der Synchronmotor (20) aufweist:

i) eine d-Achsen-Induktivität mit einem lokalen Maximalpunkt in einer positiven Richtung in Bezug auf einen positiven d-Achsenstrom, der an den Stator (21) angelegt wird, während der positive d-Achsenstrom zunimmt, und
ii) eine d-Achsen-Induktivität, die monoton abnimmt, wenn der d-Achsenstrom auf höher als der lokale Maximalpunkt zunimmt,

das Steuersystem (100) ferner umfasst:

einen Wechselrichter (15), der dazu ausgestaltet ist, einen Wechselstrom zum Antreiben des Synchronmotors (20) auszugeben;
eine Gate-Befehl-Erzeugungseinheit (14), die dazu ausgestaltet ist, einen Gate-Befehl (GC) zum Antreiben des Wechselrichters (15) zu erzeugen;
eine Stromfeststellungseinheit (16), die dazu ausgestaltet ist, einen Stromwert des Wechselstroms festzustellen, der von dem Wechselrichter (15) ausgegeben wird;
eine Magnetpolpositionsschätzungseinheit (18), die dazu ausgestaltet ist, eine Magnetpolposition basierend auf dem von der Stromfeststellungseinheit (16) festgestellten Stromwert zu schätzen und ein Schätzsignal zu erzeugen;
eine Steuereinheit (11), die bei der Bestimmung der Magnetpolpolarität die Gate-Befehlserzeugungseinheit anweist, einen Gate-Befehl zur Polaritätsbestimmung zu erzeugen, derart, dass eine d-Achsenkomponente des von der Stromfeststellungseinheit festgestellten Stromwerts einen vorbestimmten Wert darstellt; und
eine Magnetpolpolaritätsbestimmungseinheit (19), die dazu ausgestaltet ist, wenn der Gate-Befehl zur Polaritätsbestimmung erzeugt wird, basierend auf dem Schätzsignal einen ersten Induktivitätswert basierend auf einem positiven d-Achsenstrom und einen zweiten Induktivitätswert basierend auf einem negativen d-Achsenstrom zu berechnen, den ersten Induktivitätswert und den zweiten Induktivitätswert zu vergleichen und einen größeren von dem ersten Induktivitäts- und dem zweiten Induktivitätswert als einen Nordpol zu bestimmen.

2. Steuersystem (100) nach Anspruch 1, wobei der Gate-Befehl zur Polaritätsbestimmung ein Befehl ist, der angibt, dass ein Induktivitätswert, der von der d-Achsenkomponente des Stromwerts erhalten wird, einen lokalen Höchstwert oder eine Nachbarschaft des lokalen Höchstwerts darstellt.

3. Steuersystem (100) nach Anspruch 1, wobei der Synchronmotor (20) den Rotor (22) umfasst, der mehrere Magnetabschnitte umfasst, die aus zwei Magneten (27) bestehen, und
die zwei Magneten von jedem der Magnetabschnitte in einem nicht konstanten Abstand angeordnet sind, der an einem Abschnitt am nächsten an der Mitte des Rotors am kürzesten und an einem Abschnitt am weitesten von der Mitte des Rotors am längsten ist.

4. Steuersystem (100) nach Anspruch 1, wobei der Rotor mehrere Magnetabschnitte umfasst, die aus drei Magneten (27) bestehen, und zwei der drei Magneten von jedem der Magnetabschnitte in einem nicht konstanten Abstand angeordnet sind, der an einem Abschnitt am nächsten an der Mitte des Rotors (22) am kürzesten und an einem Abschnitt am weitesten von der Mitte des Rotors am längsten ist.

5. Steuersystem (100) nach Anspruch 1, wobei die Steuereinheit (11) umfasst:

> eine Wechselstrom-Erzeugungseinheit (12), die eine Wechselspannung erzeugt, die auf einer d-Achsen-Komponente des von dem Wechselrichter ausgegebenen Wechselstroms zu überlagern ist; und
>
> die Magnetpolaritätsbestimmungseinheit (19), wenn die von der Wechselspannungserzeugungseinheit erzeugte Wechselspannung überlagert wurde, und basierend auf dem von der Stromfeststellungseinheit festgestellten Stromwert die Seite, die eine höhere Amplitude des d-Achsenstroms aufweist, als den Südpol bestimmt.

## Revendications

1. Système de commande (100) qui commande un moteur synchrone (20) comprenant un stator (21) et un rotor, et ayant un aimant (27) à l'intérieur du rotor (22), le système de commande étant **caractérisé en ce que**
   le moteur synchrone (20) a :

   > i) une inductance d'axe d avec un point maximal local dans une direction positive par rapport à un courant d'axe d positif appliqué au stator (21) pendant que le courant d'axe d positif augmente, et
   >
   > ii) une inductance d'axe d qui diminue de manière monotone lorsque le courant d'axe d augmente au-dessus du point maximal local,

   le système de commande (100) comprenant en outre :

   > un onduleur (15) configuré pour délivrer un courant alternatif pour entraîner le moteur synchrone (20) ;
   > une unité de génération de commande de grille (14) configurée pour générer une commande de grille (GC) pour entraîner l'onduleur (15) ;
   > une unité de détection de courant (16) configurée pour détecter une valeur de courant du courant alternatif délivré par l'onduleur (15) ;
   > une unité d'estimation de position de pôle magnétique (18) configurée pour estimer une position de pôle magnétique sur la base de la valeur de courant détectée par l'unité de détection de courant (16) et générer un signal d'estimation ;
   > une unité de commande (11) qui instruit, lors d'une détermination de polarité de pôle magnétique, à l'unité de génération de commande de grille de générer une commande de grille pour une détermination de polarité de sorte qu'une

> composante d'axe d de la valeur de courant détectée par l'unité de détection de courant représente une valeur prédéterminée ; et
> une unité de détermination de polarité de pôle magnétique (19) configurée pour calculer, si la commande de grille pour une détermination de polarité est générée, sur la base du signal d'estimation, une première valeur d'inductance sur la base d'un courant d'axe d positif et une deuxième valeur d'inductance sur la base d'un courant d'axe d négatif, comparer la première valeur d'inductance et la deuxième valeur d'inductance, et déterminer la plus grande parmi la première valeur d'inductance et la deuxième valeur d'inductance en tant qu'un pôle nord.

2. Système de commande (100) selon la revendication 1, dans lequel la commande de grille pour une détermination de polarité est une commande indiquant qu'une valeur d'inductance obtenue d'après la composante d'axe d de la valeur de courant représente une valeur maximale locale ou un voisinage de la valeur maximale locale.

3. Système de commande (100) selon la revendication 1, dans lequel le moteur synchrone (20) inclut le rotor (22) incluant une pluralité de portions d'aimant constituées de deux aimants (27), et
   les deux aimants de chacune des portions d'aimant sont disposés à une distance non constante qui est la plus courte à une portion la plus proche du centre du rotor et la plus longue à une portion la plus éloignée du centre du rotor.

4. Système de commande (100) selon la revendication 1, dans lequel le rotor inclut une pluralité de portions d'aimant constituées de trois aimants (27), et deux parmi les trois aimants de chacune des portions d'aimant sont disposés à une distance non constante qui est la plus courte à une portion la plus proche du centre du rotor (22) et la plus longue à une portion la plus éloignée du centre du rotor.

5. Système de commande (100) selon la revendication 1, dans lequel l'unité de commande (11) inclut :

   > une unité de génération de tension alternative (12) qui génère une tension alternative à superposer sur un composant d'axe d du courant alternatif délivré par l'onduleur ; et
   > l'unité de détermination de polarité magnétique (19) détermine, lorsque la tension alternative générée par l'unité de génération de tension alternative a été superposée et sur la base de la valeur de courant détectée par l'unité de détection de courant, le côté ayant une amplitude plus grande du courant d'axe d en tant que le pôle sud.

# FIG.1

100

EP 2 869 457 B1

# FIG.2

FIG.3

FIG.4

# FIG.5

# FIG.6

## FIG.7

## FIG.8

# FIG.9

$L_d$

$i_d$

(ROTOR SIDE)

# FIG.10

$L_d$

WIDE

NARROW

NARROW

WIDE (WIDTH OF MAGNETIC-PATH-FORMING IRON CORE)

$i_d$

(ROTOR SIDE)

# FIG.11

(STATOR SIDE)

# FIG.12

(ROTOR SIDE)

FIG.13

FIG.14

## FIG.15

## FIG.16

FIG.17A

$\gamma$ AXIS
VOLTAGE

POSITIVE

NEGATIVE

TIME

FIG.17B

$i\gamma : \gamma$
AXIS
CURRENT

SOUTH POLE

TIME

NORTH POLE

# FIG.18

# FIG.19

# FIG.20

(a) γ AXIS CURRENT COMMAND

(b) γ AXIS CURRENT

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110234135 A1
- JP 2000060038 A
- JP 3719910 B
- JP 3401155 B
- JP 2008079489 A